# EUROPEAN PATENT APPLICATION

(11) **EP 0 992 607 A1**
(43) Date of publication of application: **12.04.2000**
(21) Application number: 99119615.5
(22) Date of filing: 04.10.1999
(51) Int. Cl.: C23C 14/50, C23C 16/44

(54) **Substrate holder**

(30) Priority: 07.10.1998 GB 9821752
(71) Applicant: APPLIED VISION LTD, Whitwick, Leicestershire LE67 4JP (GB)
(72) Inventor: Walls, John Michael, Crow Borough, East Sussex TN6 10W (GB); Jafer, Hussein Abidjwad, Loughborough, Leicester LG 11 4NJ (GB)
(74) Representative: Wood, Graham

(57) **Abstract**

The invention relates to a holder which can be used to support and protect a substrate during the application of material by deposition techniques such as sputter deposition or evaporation. The holder is provided with a retaining ring which engages with a housing and said retaining ring defines an opening which allows the passage of deposited material onto the exposed surface of the substrate held between the housing and ring. The substrate is urged towards the ring by a biasing means which causes the surfaces of the substrate not exposed through the opening to be sealed and hence prevents the application of deposited material thereon.

## Description

The invention which is the subject of this application relates to a device to be used in holding a substrate in a required position during the application of a coating thereon. The invention is particularly , but not exclusively, directed towards the provision of a holder for use in holding a substrate in a sputter coating chamber and by which process a coating can be applied to the surfaces of the substrate.

The use of sputter coating techniques to apply coatings to substrates, such as optical lens, is well known and the applicant has several granted and pending patents relating to this area of technology. A common problem encountered when applying coatings is that not all of the sputtered material is applied to the exposed substrate surface and excess material is applied to other surfaces in the coating chamber. This is not a major problem when the substrates are flat but, when the substrates are curved such as for example optical lens which have a concave and convex surface, and a material or materials are being sputtered on one of the surfaces, say the exposed concave surface, then the excess or back scattered sputtered material can be deposited on the other of the surfaces which in this case is the convex surface of the lens. This deposition causes surface irregularities which, when a layer of material is to be sputter deposited on the same can cause problems with the adherence of the layer to the surface.

The applicants patent no EP 714454 discloses the provision of masking means which allow the prevention of back scattered material from reaching the surface which is not being coated at that time, and the aim of this invention is to provide a holder which provides an improvement to the masking technique and include the same in the holder which in itself has advantages over conventional lens holders.

In a first aspect of the invention there is provided a substrate holder for use to support a substrate during the deposition of a material to form a coating on at least one surface of the substrate using a material deposition technique, said substrate holder comprising a housing, a support for the substrate within the housing, said housing having an opening with which an annular retaining ring is engageable and said support biased towards said retaining ring so as to trap the substrate in position between the retaining ring and support with at least a portion of a surface of the substrate exposed for the application of material thereon.

Typically the ring is an annulus, typically only slightly smaller than the outer edge of the substrate so that it is effectively the edge of the substrate which is trapped by the support and the ring and the remainder of the lens surface facing the ring is exposed for the application of material thereto. In one embodiment the retaining ring includes a rim which protrudes inwardly of the aperture at the edge of same facing the material deposition means and it is the rim which defines the size of the ring aperture to be slightly less than the substrate and which contacts with the edge of the substrate to provide the same in sealed engagement thereby preventing the passage of deposited material pas the line of seal and into the housing, so preventing the deposition of material onto other surfaces of the substrate. In one embodiment, for ease of use, the retaining ring is engageable on the housing by using bayonet engagement means.

Typically the support is biased towards a normal or relaxed position beyond the plane of the opening of the housing to which the ring is engaged with the housing so as to exert a pushing force on the substrate against the retaining ring when the ring is fitted to the housing. The support, in one embodiment, comprises a plate with an upstanding rim, which rim contacts with the substrate. The biasing means can be a spring mounted between the rear face of the housing and support plate.

The housing can also include in one embodiment, on the rear external face thereof, a locating means which allows the holder to be fitted onto a holder carrier for rotation during the application of the material to form the coating on the substrate. In one embodiment the material is deposited using sputter deposition techniques. The holder is of particular use with the applicant's sputter coating apparatus as described in their earlier patents and patent applications.

In one embodiment the substrate is an optical lens and has a convex surface and a concave surface and the support is shaped so as to allow the holder to be used to hold and expose either of the surfaces for coating.

It is clear therefore that the holder of the current invention allows the application of material to form a coating on a surface of a substrate without allowing any excess material to be applied to any other surface of the substrate. The provision of the support with biasing means ensures that the required seal between the edge of the substrate and the retaining ring is achieved and the holder can also be used time after time by an operator of the apparatus ensuring that on each occasion the required seal is achieved.

In a further aspect of the invention there is provided a method for applying a coating to at least one surface of a substrate using a material deposition technique, said method comprising the steps of placing the substrate in a substrate holder, said substrate holder comprising a housing with a support on which the substrate is placed, said support biased to urge the substrate towards an opening defined by a retaining ring, said substrate trapped between the support and retaining ring with the surface to be coated exposed to the material deposition means and the remaining surfaces of the substrate sealed by the retaining ring to prevent the passage of deposited material onto other surfaces of the substrate.

Thus, in one embodiment the method allows a substrate in the form of a lens to be coated with other surfaces protected so that the said further surfaces can subsequently be exposed for the application of material thereon, typically by the same deposition techniques by removing and replacing the substrate with another surface exposed. The said other surface will not have foreign matter applied thereto when the coating of the first takes place, thereby preventing the same from being damaged or causing failure of the subsequently applied coating.

In one embodiment, and where both the concave and convex surfaces are to be coated, once the convex face is coated, the lens is removed from the holder, the orientation of the same reversed and placed into the holder so as expose the concave face for the deposition of the material thereon. Preferably, in each case the convex face is coated first as an improved seal can be obtained with the housing when the lens is in this position.

In one embodiment the substrate holder is mounted, with a number of holders, on a holder carrier, said carrier provided for rotation in a vacuum chamber, and as the carrier rotates, the same moves past apparatus for depositing material onto said substrates to form a coating of the material or materials on the exposed surfaces of the substrates. In one embodiment the substrates are rotated past reaction producing means to cause the reaction of the sputtered material.

In an alternative embodiment the substrate holder is mounted, with a number of holders, on a holder carrier, said carrier provided for linear movement in a vacuum chamber, and as the carrier moves, the same moves past apparatus for depositing material onto said substrates to form a coating of the material or materials on the exposed surfaces of the substrates. Typically the substrates are moved past reaction producing means to cause the reaction of the sputtered material.

In a further aspect there is provided a method for applying a coating to at least one surface of a plurality of substrates using at least one material deposition means and at least one reaction producing means mounted within a vacuum chamber, said method including the steps of placing each of the substrates in a substrate holder, placing each of the substrate holders on a carrier, moving the carrier in the vacuum chamber to move the substrates past the material deposition and reaction producing means and characterised in that said substrate holder comprises a housing with a support on which the substrate is placed, said support biased to urge the substrate towards an opening defined by a retaining ring, said substrate trapped between the support and retaining ring with the surface to be coated exposed to the material deposition means and reaction producing means to allow the layer on the surface to be formed by the deposition of material and reaction thereof on the exposed surface area and the remaining surfaces of the substrate are sealed by the retaining ring to minimise the passage of deposited material onto said other surfaces.

In one embodiment the material deposition technique used is sputter deposition to cause the deposition of material particles from a target of material deposited upon operation of the magnetron. In one embodiment the reaction producing means is a plasma source or ion source such as an unbalanced magnetron. Typically a plurality of these can be provided in the vacuum chamber and operated to bring about the required coating on the substrates which can, in one embodiment be optical lens.

A specific embodiment of the invention will now be described with reference to the accompanying drawings wherein;
Figure 1 illustrates a side view of the holder in one embodiment;
Figure 2 illustrates a plan view of the holder with an optical lens held in position for coating;
Figure 3 illustrates a cross sectional end elevation along line A-A of Figure 2;
Figure 4 illustrates the view of Figure 3 with the position of the substrate reversed for the coating of another surface; and
Figure 5 illustrates the housing and support plate without the retaining ring of the holder.

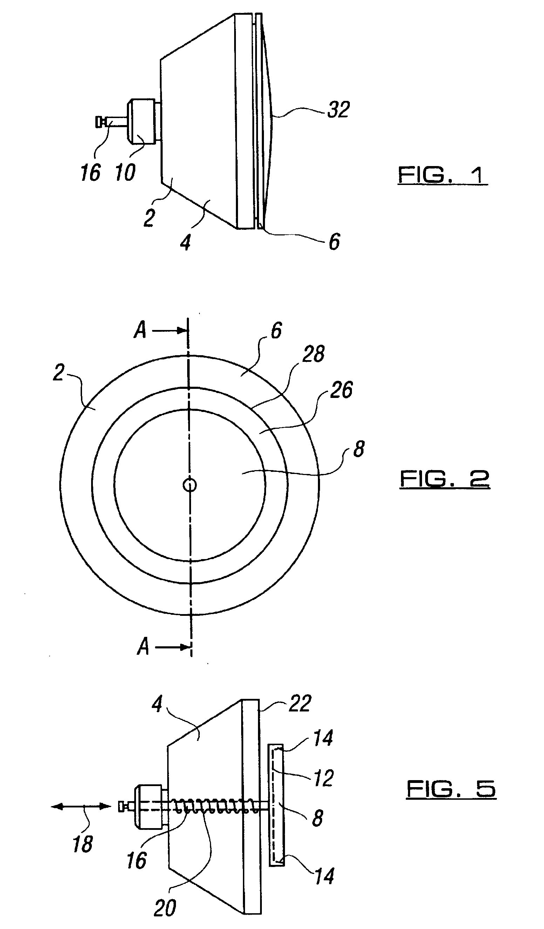

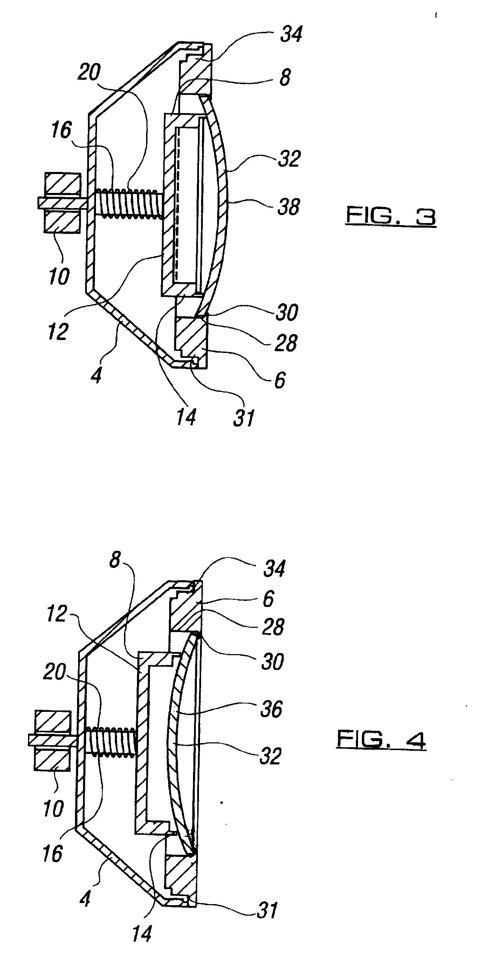

Referring firstly to Figures 1 and 2 there is illustrated a holder 2 according to the invention. The holder comprises a housing 4, a retaining ring 6 and a substrate support means 8. The housing includes a locating means 10 to allow the holder to be loaded and located on a carrier, not shown, which allows a number of said holders to be rotated during sputter deposition of material or materials to form coatings on substrates held in the holders. The apparatus used for applying the material can be of any known form, but preferred embodiments of apparatus are disclosed in the applicants co-pending applications derived from PCT/GB92/00071 and PCT/GB95/00580.

The support means 8 comprises, as is shown also in Figure 5, a plate 12 with a rim 14. The plate and rim are mounted on a member 16 which is movable as shown by arrow 18 in relation to the housing and through an aperture in the same. The movement of the member causes movement of the plate 12 and rim 14. The position of the plate and rim is biased by a spring 20 which acts to move the plate and rim to an extended or normal position which is beyond the opening 22 of the housing as shown in Figure 5.

The retaining ring comprises an aperture 26 defined by an inner wall 28 which has a rim 30 depending inwardly therefrom. The inner wall is larger than the optical lens substrate 32 and the substrate passes through the aperture to contact with the rim 30 as shown in Figures 3 and 4. The outer wall 31 of the ring is stepped as shown and includes in conjunction with the inner wall of the housing 4 at the opening 22, bayonet fittings 34 which allow engagement of the ring with the housing. This means that when the lens is in position on the support 8 and forced by the support under the action of the spring 20 against the retaining ring in position in the housing, the housing opening 22 is completely sealed. The ability to seal the housing opening prevents any sputtered material from entering the same.

In use therefore, the lens has a concave surface 36 and a convex surface 38. In this example, although this is not always the case, both of the surfaces 36,38 are to be coated. The lens is therefore placed on the support 8 with the concave surface contacting the rim 14 of the support and the convex surface is the face to be coated as shown in Figure 3. With the lens in position, the retaining ring is moved into location on the housing and the lens is then trapped between the rim 30 on the retaining ring and the support 8. This therefore means that substantially all of the convex surface of the lens is exposed for the sputter deposition of material thereon to form the coating. It is also found that sputter deposited material can also pass onto the edge of the lens in contact with the rim of the retaining ring so that substantially all of the convex surface is coated and no back scattered material can reach the concave surface which is kept clean. When the deposition is complete, the retaining ring is removed, the lens turned round and the clean concave surface 36 exposed as shown in Figure 4 for the application of material thereon without the conventional problems of backscattered material and lack of adhesion of the applied material.

A further reason for always coating the convex face first is that in general an efficient seal can be obtained between the lens and the housing thus preventing any backscattered material from reaching the uncoated concave face. When reversed and the concave face is exposed for the application of the coating thereon it is found on occasion, and especially if the lens includes a "cylinder" shaping to take into account the problem of astigmatism which can provide an irregular edge of the lens, that the seal with the housing may not be as secure and some deposited material may reach the convex face. However, as the convex face has previously been coated, the back scattered material has no adverse effect on the same.

The present invention therefore provides a holder for a substrate which allows a surface of the substrate to be exposed for the application of material thereon while at the same time preventing the application of material onto another surface or surfaces of the substrate at least until the said surface or surfaces is/are itself coated. The holder also acts as a means to allow the seal between the substrate and holder to be obtained on each occasion while allowing relatively simple and efficient retention of the lens in position for coating as well as allowing relatively easy loading and unloading of the holder on the substrate carrier for coating.

## Claims

1. A substrate holder (2) for supporting a substrate (32) during the deposition of a material to form a coating on at least one surface of the substrate using a material deposition technique, characterised in that said substrate holder (2) comprises a housing (4), a support (8) for the substrate within the housing, said housing having an opening (22) with which a retaining ring (6) is engageable and said support biased towards said retaining ring so as to trap the substrate in position between the retaining ring and support with at least a portion of a surface of the substrate exposed for the application of material thereon.

2. A substrate holder according to claim 1 characterised in that the retaining ring includes a rim which protrudes inwardly toward the substrate at an inner edge of the aperture defined by the ring.

3. A substrate holder according to claim 2 characterised in that the inner rim of the retaining ring defines the area of the substrate surface which is exposed for the application of material thereon.

4. A substrate holder according to claim 1 characterised in that the substrate is held in sealed engagement around the peripheral edge of the same with the holder when trapped between the retaining ring and support.

5. A substrate holder according to claim 1 characterised in that the retaining ring is provided with engagement means to engage the ring with the housing.

6. A substrate holder according to claim 1 characterised in that the support comprises a plate which contacts with the substrate.

7. A substrate holder according to claim 6 characterised in that the support is biased towards the retaining ring by a spring mounted between a rear face of the housing and the support plate.

8. A substrate holder according to claim 1 characterised in that the housing is provided with a locating means to allow the holder to be releasably fitted onto a carrier for a plurality of said holders.

9. A substrate holder according to claim 1 characterised in that the material deposition technique used to apply the material is sputter deposition technique.

10. A substrate holder according to any preceding claim characterised in that the substrate is an optical lens having concave and convex surfaces and substantially all of one of the concave or convex surfaces is exposed for the application of material thereon when held in the substrate holder.

11. A method for applying a coating to at least one surface of a substrate (32) using a material deposition technique, said method including the steps of placing the substrate (32) in a substrate holder, characterised in that said substrate holder comprises a housing (4) with a support (8) on which the substrate is placed, said support biased to urge the substrate towards an opening (22) defined by a retaining ring (6), said substrate trapped between the support and retaining ring with the surface to be coated exposed to the material deposition means to allow the layer on the surface to be formed by the deposition of material thereon and the remaining surfaces of the substrate sealed by the retaining ring to minimise the passage of deposited material onto said other surfaces.

12. A method according to claim 11 characterised in that the substrate is an optical lens with concave and convex surfaces and said substrate is placed in said substrate holder with one of the said convex and concave surfaces exposed for the deposition of material thereon and said substrate holder prevents any of the material from reaching the other of the convex and concave surface of the substrate.

13. A method according to claim 12 characterised in that once the first of the convex or concave surfaces is coated, the substrate is removed from the holder, the orientation of the same is reversed and the substrate is placed in the holder with the other of the convex and concave surfaces exposed for the deposition of material thereon.

14. A method according to claim 11 characterised in that the substrate holder is mounted, with a number of holders, on a holder carrier, said carrier provided for rotation in a vacuum chamber, and as the carrier rotates, the same moves past apparatus for depositing material onto said substrates to form a coating of the material or materials on the exposed surfaces of the substrates.

15. A method according to claim 11 characterised in that the substrate holder is mounted, with a number of holders, on a holder carrier, said carrier provided for linear movement in a vacuum chamber, and as the carrier moves, the same moves past apparatus for depositing material onto said substrates to form a coating of the material or materials on the exposed surfaces of the substrates.

16. A method according to claims 14 or 15 characterised in that the substrates are moved past reaction producing means to cause the reaction of the sputtered material.

17. A method for applying a coating to at least one surface of a plurality of substrates (32) using at least one material deposition means and at least one reaction producing means mounted within a vacuum chamber, said method including the steps of placing each of the substrates in a substrate holder, placing each of the substrate holders on a carrier, moving the carrier in the vacuum chamber to move the substrates past the material deposition and reaction producing means and characterised in that said substrate holder comprises a housing (4) with a support (8) on which the substrate is placed, said support biased to urge the substrate towards an opening (22) defined by a retaining ring (6), said substrate trapped between the support and retaining ring with the surface to be coated exposed to the material deposition means and reaction producing means to allow the layer on the surface to be formed by the deposition of material and reaction thereof on the exposed surface area and the remaining surfaces of the substrate are sealed by the retaining ring to minimise the passage of deposited material onto said other surfaces.
